(19) Europäisches Patentamt
European Patent Office
Office européen des brevets

(11) EP 4 708 158 A1

(12) **EUROPEAN PATENT APPLICATION**

(43) Date of publication:
11.03.2026 Bulletin 2026/11

(21) Application number: 25200048.4

(22) Date of filing: 03.09.2025

(51) International Patent Classification (IPC):
$G06N\ 20/00^{(2019.01)}$ $G01R\ 31/36^{(2020.01)}$

(52) Cooperative Patent Classification (CPC):
**G06N 20/00;** G01R 31/2836; G01R 31/367

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **05.09.2024 US 202463690856 P
29.08.2025 US 202519315271**

(71) Applicant: **Analog Devices, Inc.
Wilmington, MA 01887 (US)**

(72) Inventors:
• **KELKAR, Varun**
**Wilmington, 01887 (US)**
• **EROL, Melihcan**
**Wilmington, 01887 (US)**
• **RAMAN, Ravi Kiran**
**Wilmington, 01887 (US)**
• **TANOVIC, Omer**
**Wilmington, 01887 (US)**

(74) Representative: **Wallin, Nicholas James
Withers & Rogers LLP
2 London Bridge
London SE1 9RA (GB)**

(54) **TRANSFER LEARNING DOMAIN ADAPTATION**

(57) System and techniques for adapting one domain to another to facilitate transfer learning in a machine learning (ML) model are described herein. Given data from a source domain and a target domain, moments can be mapped from the source domain to the target domain. Synthetic data that is constrained by the mapping can be created in the target domain. The synthetic data can be combined with the target domain data to create training data for a machine learning model to enable the model to be trained to accept target domain data as input and produce an output.

Processed by Luminess, 75001 PARIS (FR)

# EP 4 708 158 A1

## Description

### CLAIM OF PRIORITY

This patent application claims the benefit of priorityto United States Provisional Application Serial No. 63/690,856, titled "ENHANCED DOMAIN ADAPTATION VIA REGULARIZED OPTIMAL TRANSPORT" and filed on September 5, 2024, the entirety of which is hereby incorporated by reference herein.

### TECHNICAL FIELD

Embodiments described herein generally relate to automated test equipment and more specifically to transfer learning domain adaptation.

### BACKGROUND

Automated Testing Equipment (ATE) in manufacturing can include computer-controlled systems designed to test or to validate the functionality, performance, or safety of products. ATE systems can be integrated into manufacturing workflows to perform electrical, mechanical, or functional testing with minimal human intervention. ATE can include end-of-line (EOL) testing, which verifies that a product meets required specifications, or can categorize a performance aspect of a product, after the final stage of assembly. EOL testing can include measurements such as voltage, current, impedance, or signal integrity depending on the product type. For example, in battery production, ATE systems can be used to test parameters such as state of charge, capacity, internal resistance, or thermal behavior to ensure compliance with performance and safety standards. ATE has been used for a variety of products, such as printed circuit boards, power modules, or sensors, where test coverage and repeatability help to maintain quality and reliability at high manufacturing volumes.

Artificial intelligence (AI) refers to a broad set of computational methods that enable machines to perform tasks typically requiring human intelligence, such as perception, decision-making, or pattern recognition. AI generally includes machine learning (ML), in which an ML model is trained using large datasets to identify patterns or make predictions. The training process usually involves optimizing model parameters (e.g., synaptic weights) to minimize errors between predicted outputs and actual outcomes, often using techniques such as gradient descent in supervised or unsupervised learning contexts. For example, ML models can be trained on labeled data to perform classification or regression tasks or on unlabeled data to uncover underlying structures (e.g., patterns). In automated testing applications, ML models can enhance the capabilities of traditional ATE by enabling predictive maintenance, anomaly detection, or adaptive testing strategies. For instance, ML models can analyze historical test data to identify patterns indicative of latent defects or forecast equipment failures, enabling more efficient test scheduling or reduced downtime.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.

FIG. 1 is a block diagram of an example of an environment including a system for transfer learning domain adaptation, according to an embodiment.

FIG. 2 illustrates an example of transport from a source domain to a target domain, according to an embodiment.

FIG. 3 illustrates an example of different domain transfer fitting results, according to an embodiment.

FIG. 4. illustrates an example of smearing sparse data in a data domain, according to an embodiment.

FIG. 5 illustrates an example of machine learning to generate a transport from between latent data space embedding of source domain data and latent data space embedding of target domain data, according to an embodiment

FIG. 6 illustrates an example of inference of target domain data using a machine-learning model trained on source domain data, according to an embodiment.

FIG. 7 illustrates an example of inference of target domain data using a machine-learning model trained on source domain data transformed to the target domain using a transport map, according to an embodiment.

FIG. 8 illustrates a flow diagram of an example of a method for transfer learning domain adaptation, according to an embodiment.

FIG. 9 is a block diagram illustrating an example of a machine upon which one or more embodiments may be implemented.

## DETAILED DESCRIPTION

In general to produce effective ML models, the ML model training depends on large volumes of high-quality (e.g., accurate, well distributed across the problem domain, etc.) data to achieve accurate and generalizable performance. However, acquiring such data presents significant challenges in manufacturing environments. Data collection can be expensive or time-consuming, particularly when the data collection involves generating experimental test cases or capturing measurements across diverse product variants. Furthermore, data can be sparse for certain failure modes or rare defect classes, limiting the ability of ML models to be trained to properly address (e.g., accurately classify, predict, etc.) these scenarios. In many cases, labeled data requires expert annotation or detailed experimentation, which further increases cost and reduces scalability.

Transfer learning provides a mechanism to address these challenges by adapting knowledge from a data-rich source domain to a data-sparse target domain. This approach is especially useful when direct data acquisition for the target domain is limited or impractical. Techniques such as Optimal Transport can be used to align the distributions of source and target data, enabling more effective transfer of learned representations. Optimal Transport (OT) is a mathematical framework that finds the most efficient way to transform one probability distribution into another by minimizing a transport cost. In the ML context, OT can be used to align data distributions across different domains. This alignment helps models trained on a source domain adapt better to a target domain with different characteristics. For example, Sliced Wasserstein Optimal Transport offers a computationally efficient method to learn transformation maps between domains, enabling the reuse of existing model architectures and reducing the dependency on large-scale labeled data in the target domain. This capability enhances the practicality of deploying ML-driven improvements in automated testing across variable production scenarios.

While Sliced Wasserstein Optimal Transport enables efficient domain adaptation, Sliced Wasserstein Optimal Transport can sometimes be excessively powerful in mapping more distributed source domain data with the sparse data points in the target domain data, resulting in mappings that do not reflect meaningful structural relationships in the data. This issue can be particularly relevant when working with sensor data, where the measurement space in the target domain may be partially observed due to limitations in allowable test configurations or operational constraints. In such cases, the target distribution may be underrepresented or incomplete after Sliced Wasserstein Optimal Transport is applied.

To address the issues with Sliced Wasserstein Optimal transport, smear regularization can be applied to the target domain data to expand the observed data points by intelligently distributing or "smearing" data points in the target domain across the unobserved regions (e.g., gaps) of the domain. Smear regularization enables more uniform distributional coverage of data in the target domain before Sliced Wasserstein Optimal transport is-or other types of Optimal Transports or transport (e.g., transformations) between the target and source domains are-applied without requiring additional measurements, improving the robustness and stability of the learned transformation map and enhancing the reliability of transfer learning in automated testing applications.

An approach to smearing involves using statistical moments of only the target domain to identify a functional mapping to interpolate data in the unobserved section of the data space (e.g., conditional means of the target $\mathbb{E}[x_T|y_i]$). While straightforward, this approach generally enables a fit to low-order polynomials. However, the greater data density in the source domain can enable better determination of statistical moments and bring the structure of these moments (e.g., conditional means of the source domain $\mathbb{E}[x_S|y_i]$) into the target domain to constrain smearing in the target domain. This approach can enable more complex smearing functions to be applied in the creation of synthetic data in the data sparse target domain using the source data. Accordingly, the ability to, for example, apply the Optimal Transport to move data from the source domain to the target domain, or the other way around, is improved. In the former case, this improvement provides an abundance of training data to train an ML model on the target domain to produce results (e.g., inferences, classifications, etc.). In the latter case, the target domain data can be transformed in order to be acted upon directly by an ML model already trained in the source domain. In either case, the functioning of ML model use to produce results for the target domain is improved. Additional details and examples are described below.

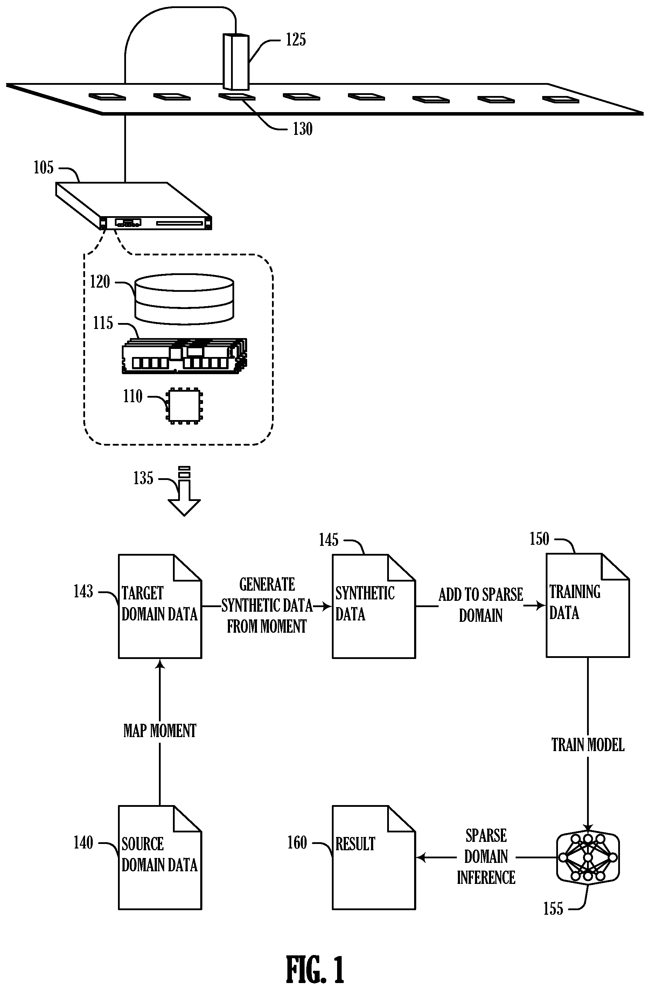

FIG. 1 is a block diagram of an example of an environment including a system 105 for transfer learning domain adaptation, according to an embodiment. The system 105 includes processing circuitry 110, storage 120 (e.g., power-stable storage such as a hard drive, solid state drive, etc.), and memory 115. The memory 115 is generally used to maintain running state information for the system 105 that is usually discarded between system power cycles or restarts. The memory 115 and the storage 120 are both forms of computer readable media. The processing circuitry 110-or software residing in the memory 115 or storage 120 executing on the processing circuitry 110-configure the system 105 to perform various operations when running (e.g., when in operation 135).

The system can include, be coupled to (e.g., via an interface), or receive data derived from a sensor 125. In the illustrated scenario, the sensor 125 can be part of an ATE component taking a measurement for a product 130. In an example, the measurement can be one of a set of measurements of the product 130. As noted above, in the context of manufacturing, such measurements can be used to verify compliance with requirements (e.g., manufacturing tolerances), to classify the product (e.g., into one of several a performance categories), or to otherwise aid in the manufacturing process. While the example illustrated and some examples discussed below are given in the context of manufacturing, the technique is generally applicable to improving transport processes used to apply the ML model 155 trained on a source domain to a target domain.

As used here, the term "target domain" means the data domain targeted for use with ML model 155 and the "source domain" is the data domain with sufficient data to train the ML model 155 or a similar ML model. These relationships generally arise when the target domain has insufficient data points to effectively train a model. Accordingly, in an example, the data in the target domain is sparse. Generally, sparsity refers to a proportion of present data to missing data in a dataset. This proportion can be estimated by the absence of data over a window in a dimension of the target domain. For example, if the dimension were human height and there were no values between five feet and six feet, this window in the dimension of height is missing data because it is expected but missing. In an example, "sparse" means that the data includes a gap (e.g., a window of missing information) beyond a threshold (e.g., the gap has a magnitude within a dimension) within the target domain. Thus, in the context of transfer learning, data from the source domain will be used to fill out the data in the target domain to enable a sufficient amount of data in the target domain to train the ML model.

At a high level, the technique to improve transfer learning in an ML model involves smearing target domain data to improve the results of the transport function. Smearing creates synthetic data based on (e.g., anchored at) data points in the target domain data. This synthetic data provides additional elements for the transport process to operate upon, improving the results of the transport process and thus improving the performance in training the ML model 155 on the target domain or on performance of an ML model trained for the source domain operating on data from the target domain transported to the source domain.

As noted above, the synthetic data is based on, or anchored at, data points in the target domain. In addition to the data points in the target domain, there is a question of constraints on the synthetic data, such as boundaries, data density, etc., that can govern where and how much synthetic data is created in the target domain. While these constraints can be based on the target domain-for example, assuming that the sparse data in the target domain provides a good description of the target domain (e.g., boundaries, mean, media, etc.)-it can be more effective to adopt constraints from the source domain because the source domain is more fully represented by the data in the source domain. An example of such constraints can include moments-quantitative measures of statistical distributions-from the source domain. Moments such as means or variances, for example, conditioned on a metric such as temperature, can be matched from the source domain to the target domain to leverage smearing regularization in the target domain to sample data at the matched moments.

In an example, moment matching can include matching multiple moments with, for example, constrained low-dimensional functional forms to derive closer approximation of source domain and target domain distributions. In an example, this can include using one or more different functional forms, such as polynomial or rational forms among others. In an example, inter-feature correlations in vector embeddings (e.g., latent embedded spaces) can be incorporated using moment matching. In an example, different order moments can be used, such as mean, variance, skew, kurtosis, etc. can be used.

In an example, the moment matching from a source domain moment to a target domain can be used to constrain optimal transport techniques to facilitate distributional correspondence between the data domains. Here, a constrained lower-dimensional optimal transport map can be learned from the source domain such that conditional distributions of the transformed source data can be matched to the target domain. In an example, this can include target domain smearing as part of the optimal transport map optimization. In an example, optimization can be addressed using gradient-based techniques, such as gradient descent, momentum, Adaptive Moment Estimation (ADAM), etc. In an example, one or more multiple dependent variables, such as temperature, system-on-a-chip (SoC), current, age, can be used in the technique.

In an example, correspondence of dependent variables in the source domain to the target domain can be used. For example, a conditional distribution of the source domain and the target can be matched at the same temperature (e.g., dependent variable). This can be used to enforce simpler constraints-such as monotonicity or one-to-one correspondence of the dependent variables in the source domain and the target domain-to enable the technique to be generalized.

With respect to the system 105 implementing transfer learning domain adaptation, the following examples are given from the perspective of the processing circuitry 110 being configured during manufacture (e.g., hardwired), configured during operation (e.g., via software instructions stored in the storage 120 or the memory 115), or a combination of the two. The processing circuitry 110 is configured to access media-such as the memory 115, the storage 120, a buffer in the sensor 125, etc. (e.g., via an interface)-that includes first data in the source domain (e.g., source domain data 140) is accessed. In an example, the source domain data 140 is a first set of measurements for a first product. In an example, the first product is of a type. In an example, the type is a battery. Other examples of type, could include a housing, a power supply, etc. As noted below, the type is generally maintained between different products from which data is measured to produce the source data and the target data. For example, where the type is "battery," the source and target domains correspond to different batteries.

The processing circuitry 110 is configured to derive a moment from the first data (e.g., the source domain data 140). The "moment" is a quantitative measure of a statistical distribution. In an example, the moment is a mean or a variance. Other types of moments can include skewness, kurtosis, hyperskewness, or hypertailedness. In an example, the moment is a conditional (e.g., conditioned on a dependent variable from the source domain). In an example, a condition of the moment is temperature, current, or age. These conditions generally relate to battery operation. Other conditions (e.g., labels or states) can be appropriate for other types of products.

The processing circuitry 110 is configured to access second media (e.g., which can be the same as the first media or different than the first media) that includes second data in the target domain (e.g., target domain data 143). In an example, the second data is sparse in the target domain. As noted above, this sparsity means that the second data includes a gap beyond a threshold.

In an example, the target domain data 143 is a second set of measurements for a second product. In an example, the first produce and the second product are different products of the same type. In an example, where the type is a battery, the first product has a different chemistry or a different form factor than the second product. In an example, the first set of measurements and the second set of measurements include respective electrochemical impedance spectroscopy (EIS) data, voltage, current, or state-of-charge data for the first product and the second product.

The processing circuitry 110 is configured to create synthetic data 145 for the target domain based on the moment. In an example, where the target domain data 143 includes a gap, the synthetic data 145 fills a portion of the gap in the target domain to create training data 150. In an example, creating the synthetic data 145 based on the moment includes smearing a portion of the target domain data 143 to fill the portion of the gap, the smearing constrained by the moment.

The processing circuitry 110 is configured to create the training data 150 from the synthetic data 145 and the second data (e.g., the target domain data 143). Here, the target domain data 143 is supplemented with the synthetic data 145 to create an apparent greater density in the target domain. In an example, creating training data from the synthetic data 145 and the second data includes combining the synthetic data and the second data to create interim data. This interim data provides a point from which to further process the combination of the synthetic data 145 and the target domain data 143 for various purposes.

In an example, a transform is created to map the first data (e.g., the source domain data 140) to the interim data via a training process to map a data point from the source domain to a corresponding data point in the target domain. In an example, the transform is applied to the first data to provide additional synthetic data. Here, the transform translates, or transports, data points from the source domain data 140 into the target domain. This is a type of synthetic data because the data was not directly measured in the target domain. However, this type of synthetic data differs from the smearing described above in that the smearing is the generation of data from the target domain data 143, this generation constrained by the moment derived from the source domain data.

In an example, the additional synthetic data is combined with the interim data. In an example, the transform is a type of optimal transport from the source domain to the target domain. In an example, Sliced Wasserstein Transport (SWT) is used as a loss function in the training process to obtain the optimal transport from the source domain to the target domain.

The processing circuitry 110 is configured to train the ML model 155 using the training data 150. In an example, the ML model 155 is trained to accept the target domain data 143 as input and produce an output 160. As noted elsewhere, the output 160 can be an inference, classification, or prediction. In an example, the prediction is a product failure metric. In an example, where the second product is a battery, the output 160 from the machine learning model 155 is a core temperature of the battery.

The system 105 described above enables characteristics of the source domain data 140, as captured by the moment, to fill out the target domain data 143 with synthetic data 145 in a manner consistent with the source domain data 140. Constraining the synthetic data 145 in this manner enables a better environment for an optimal transport, or other transform, to import the source domain data 140 into the target domain to address the overfitting issue that these techniques can experience.

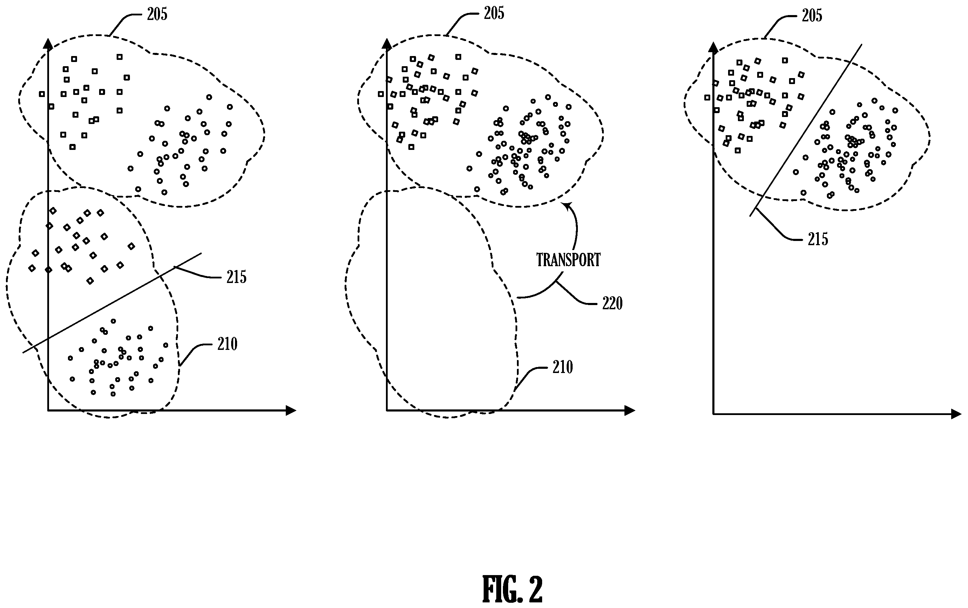

FIG. 2 illustrates an example of transport from a source domain 210 to a target domain 205, according to an embodiment. The original state, on the left, includes a target domain 205 and a source domain 210. The marker 215 demonstrates a relationship between the square data points and the circle data points in the source domain 210. The transport 220 (e.g., a transport map) is applied to the data points in the source domain 210 to transport these data points to the target domain 205. The rightmost portion includes the marker 215 in the target domain 205 to illustrate that the transport 220 preserved the relative relationship between the square data points and the circle data points from the source domain 210 in the target domain 205.

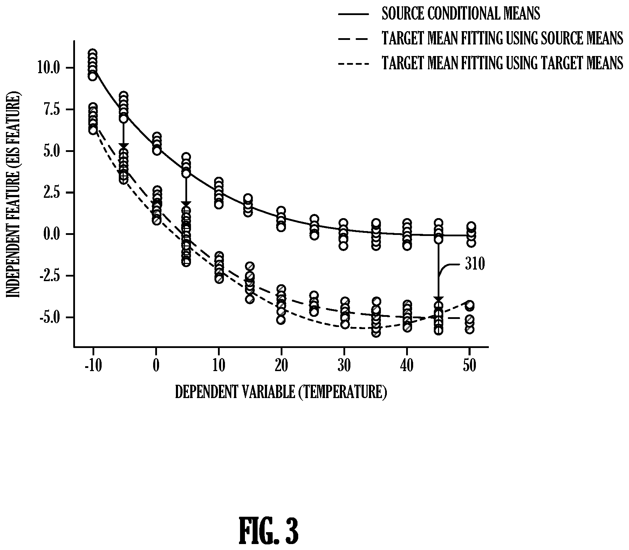

FIG. 3 illustrates an example of different domain transfer fitting results, according to an embodiment. The illustrated chart plots the creation of synthetic data 310 in a target domain based on two different approaches, a moment derived from the target domain-labeled in the chart as target mean fitting using target means-and a moment derived from the source domain, labeled in the chart as target mean fitting using source means. These moments are conditional on temperature and relate to the battery testing metric EIS. The following provides additional information with respect to this battery specific example of using transfer learning for domain adaptation.

In general, data-driven models developed to address complex inference tasks have catalyzed the emergence of technologies that enable sensor-based monitoring or control of physical environments. These capabilities are supported by advances in computational capacity and the availability of large, labeled datasets for model training. The performance of such models is strongly influenced by the volume and quality of the training data. However, collecting labeled data is often costly, time-intensive, or infeasible, thereby constraining the training of machine learning models for inference tasks.

Transfer learning (TL) mitigates this issue by leveraging models or data from a data-rich source domain to support inference in a data-sparse target domain. Traditional TL approaches frequently assume that source and target domains exhibit similar sampling distributions, including sufficient coverage of label space. In practice, this assumption may not hold due to limitations in experimental resources or data acquisition constraints. For example, sensor-driven applications such as inertial measurement unit (IMU)-based pose estimation or smart agriculture yield estimation use labeled training data across diverse conditions, which is often expensive or time-consuming to collect.

While it can be feasible to obtain adequate training data in an initial source domain (e.g., sensor measurements from agricultural fields in one geographic region), replicating this effort across multiple analogous domains (e.g., fields in another region or country) may not be practical. Consequently, the target domain may lack sufficient labeled data in both volume and diversity, impairing the training of effective inference models. Domain adaptation techniques, such as Domain-Adversarial Neural Networks (DANN), Maximum Mean Discrepancy (MMD)-based methods, and optimal transport (OT)-based approaches, address this challenge by aligning the feature distributions between source and target domains, thus enabling data augmentation and improved model training in the target domain.

An alternative strategy involves fine-tuning pre-trained models using limited target domain data. This is typically achieved by adjusting a subset of model parameters while applying regularization to constrain divergence from the original model. Multi-source transfer learning extends this idea by aggregating information from multiple source domains to improve performance. Despite the variety of existing approaches, most rely on the assumption that the target domain sampling is analogous to the source domain in terms of label diversity and feature structure. In scenarios where this assumption fails-such as partially observed target domains-these techniques risk overfitting and lack formal guarantees about which aspects of the source structure are effectively transferred.

The following examples described a domain adaptation technique configured to augment training data in a target domain using data from a source domain. Here, a regression model can be learned for estimation tasks. While the technique is broadly applicable, the following examples specifically demonstrate the use of the technique in estimating battery core temperature for new battery types with differing chemistries or form factors.

The problem can be formulated in the following manner. Consider a domain $D$ comprising feature vectors

$X_D \in \mathbb{X}_D \subseteq \mathbb{R}^k$ and label vectors $Y_D \in \Upsilon_D \subseteq \mathbb{R}^k$ drawn according to the distribution

$(X_D, Y_D) \sim \mathbb{P}_D$, where $X_D, Y_D$ are vector spaces. Assume that the dataset has $n_D$ samples:

$$\mathbb{D}_D = \mathbb{X}_D \times \mathbb{Y}_D = \left\{ \left( X_D^{(i)}, Y_D^{(i)} \right) \right\}_{i \in [n_D]}$$

Consider the regression problem focused on estimating a function $g_D : \mathbb{R}^d \rightarrow \mathbb{R}^k$ such *that* $Y_D \approx g_D(X_D)$.

The following address two domains called the source $S$, and target $T$. The domains and corresponding feature and label vector will be referenced in the following with these corresponding subscripts. Presume that $S$ is data rich and $T$ is data sparse, such that $n_S \gg n_T$. It is assumed that the labels are drawn from the same subspace, e.g.,

$\Upsilon_S = \Upsilon_T = \Upsilon \subset \mathbb{R}^d$ and their priors are the same, $\mathbb{P}_S(Y_S) = \mathbb{P}_T(Y_T)$. In an example, sampled training labels can differ across domains.

Additionally, it is assumed that $T$ is partially observed, such that the target dataset spans a small subset of the space of labels owing to experimental limitations. In contrast, the source domain data is assumed to spans $Y$.

Given the above, the following described details of a technique for domain adaptation to augment the target dataset using insights from the source domain. Consider, for any domain $D$, without loss of generality,

$$X_D = \mu_D(T_D) + \Sigma_D^{1/2}(Y_D)Z_D \quad (1)$$

Where $Z_D \sim f_Z(\cdot\,; \theta_D|)$ is a random vector with $\mathbb{E}[Z_D | Y_D] = 0$, $Cov(Z_D | Y_D) = \mathbb{I}_d$, and $\theta_D$ are hyperparameters that define the distribution. Here

$$\mu_D(Y_D) = \mathbb{E}[X_D|Y_D], \Sigma_D(Y_D) = Cov\,(X_D|Y_D)$$

For ease of exposition, let $\mu = \mu(Y)$ and $\sigma = \Sigma^{1/2}(Y)$. Thus, if $Z \sim f_Z(\cdot\,; \theta_T)$ can be sampled, feature vectors in $T$ corresponding to a label $Y_T$ can be sampled by shifting or scaling $Z$ according to $\mu_T$, $\sigma_T$ respectively.

A source driven smearing transformation can be defined as,

$$\Phi(Z, Y; h_\mu, h_\sigma, \theta) = h_\mu(\mu_S(Y)) + h_\sigma(\sigma_S(Y))Z \quad (2)$$

where $Z \sim f_Z(\cdot\,; \theta)$. Here $h_\mu: \mathbb{R}^d \to \mathbb{R}^d$ and $h_\sigma: \mathbb{R}^{d \times d} \to \mathbb{R}^{d \times d}$ are functions that transform $\mu_S$, $\sigma_S$.

Let $\mathbb{P}_{\Phi,\theta}$ be the join distribution of data drawn according to (2). Thus, the technique can be expressed as:

Input: Target sample labels: $\hat{Y}_T = \{\hat{y}_1, \hat{y}_2, \ldots, \hat{y}_{nt}\}$
Data:

$$\mathbb{D}_S = \mathbb{X}_S \times \mathbb{Y}_S, \mathbb{D}_T = \mathbb{X}_T \times \mathbb{Y}_T$$

Result: Augmented Target Dataset: $\widehat{\mathbb{D}}_T$

1. Estimate conditional moment functions for $S$, $\hat{\mu}_S(y)$, $\hat{\sigma}_s(y)$ for $y \in Y_S$ using $\mathbb{D}_S$

2. Compute empirical conditional moments for $T$, $\hat{\mu}_T(y)$, $\hat{\sigma}_T(y)$ for $y \in \mathbb{Y}_T$

3. $h_\mu \leftarrow \arg\min h \in H_\mu \sum_{y \in \mathbb{Y}_T} \left\| h(\hat{\mu}_S(y)) - \hat{\mu}_T(y) \right\|_2^2$

4. $h_\sigma \leftarrow \arg\min h \in H_\sigma \sum_{y \in \mathbb{Y}_T} \left\| h(\hat{\sigma}_S(y)) - \hat{\sigma}_T(y) \right\|_F^2$

5. Sample $Z_1, \ldots, Z_{nT} \overset{i.i.d.}{\sim} f_Z(\cdot\,; \theta_T)$

6. Generate $\hat{X}_i = \Phi(Z_i, y_i; h_\mu, h_\sigma)$, $\forall i \in [n_T]$ as in (2)

7. Return $\widehat{\mathbb{D}}_T = \mathbb{D}_T \cup \{(\hat{X}_i, y_i), \forall i \in [n_T]\}$

The technique can be used to generate an augmented target dataset $\widehat{\mathbb{D}}_T$ spanning a desired set of labels $\hat{Y}_T = \{\hat{v}_1, \hat{v}_2, \ldots, \hat{v}_{nT}\}$. The regressor $g_T$ can then be trained on $\widehat{\mathbb{D}}_T$. The regressor would be effective over $T$ if $\mathbb{P}_{\Phi,\theta_T}$ is similar to $\mathbb{P}_T$. The efficacy of the technique can be demonstrated by evaluating the Wasserstein 2-distance ($W_2$) between distributions. The $W_2$ distance between any two distributions $p$, $q$ for $X_1 \sim p$, $X_2 \sim q$ is defined as,

$$W_2(p, q) = \inf_{\gamma \in \Gamma(p,q)} \sqrt{\mathbb{E}_{(X_1,X_2) \sim \gamma}[\|X_1 - X_2\|_2^2]} \quad (3)$$

where $\Gamma(p, q)$ is the set of all couplings of $p$, $q$.
For any functions $h_\mu$, $h_\sigma$, for $Z \sim f_Z(\cdot\,; \theta_T)$,

$$W_2^2\left(\mathbb{P}_{\Phi,\theta_T}; \mathbb{P}_T\right)$$

$$\leq \mathbb{E}\left[\left\|h_\mu \circ \mu_S - \mu_T\right\|_2^2 + \left\|h_\sigma \circ \sigma_S - \sigma_T\right\|_F^2\right] \quad (4)$$

If it assumed that $\mu = h_\mu \circ \mu_S$, $\sigma = h_\sigma \circ \sigma_S$, then

$$W_2^2\left(\mathbb{P}_{\Phi,\theta_T}; \mathbb{P}_T\right)$$

$$= \inf_\gamma \mathbb{E}\left[\|\mu + \sigma Z_1 - (\mu_T + \sigma Z_2)\|_2^2\right] + \mathbb{E}[\|Y_1 = Y_2\|_2^2] \quad (5)$$

$$\leq \mathbb{E}\left[\mathbb{E}[\|\mu + \sigma Z - (\mu_T + \sigma_T Z)\|_2^2 | Y_1 = Y_2 = Y]\right] \quad (6)$$

$$= \mathbb{E}\left[\mathbb{E}[\|\mu - \mu_T\|_2^2 + \|\sigma - \sigma_T)Z\|_2^2 | Y_1 = Y_2 = Y]\right] \quad (7)$$

$$= \mathbb{E}[\|\mu - \mu_T\|_2^2] + \mathbb{E}\left[tr\left((\sigma - \sigma_T)(\sigma - \sigma_T)^T\right)\right] \quad (8)$$

where (5) follows from (1), (6) follows bounding the distance under a coupling $y$ such that $Z_1 = Z_2 = Z$ and $Y_1 = Y_2 = Y$. Further, (7) follows from the fact that

$$\mathbb{E}[2\langle\mu - \mu_T, (\sigma - \sigma_T)Z\rangle | Y_T = Y] = 0$$

since $\mathbb{E}[Z | Y_T = Y] = 0$. (8) follows as $\mathbb{E}[Z | Y_T = Y] = 0, \mathbb{E}[Z^2 | Y_T = Y] = \mathbb{I}_d, Cov\left((\sigma - \sigma_T)Z | Y_T = Y\right) = (\sigma = \sigma_T)\mathbb{I}_d(\sigma - \sigma_T)^T$. Thus, (4) follows (8) from the definition of the Frobenius norm.

Accordingly, the technique minimizes the upper bound in (4) to learn accurate proxies to $\mu_T$, $\sigma_T$ based on the limited target domain data. When $Z_T$ is independent of the label $Y_T$, data from the $\mathbb{D}_T$ can be resampled to sample $Z \sim f_Z$ $(\cdot; \theta_T)$. Thus, for feature spaces that preserve such independence, target dataset can be augmented according to this technique. In an example, if $X$ represents a feature vector where the label vector $Y$ is disentangled from extraneous factors, $Z$ can be thought of as being approximately independent of $Y$.

Given the above, the following experimental setup can be employed to demonstrate the effectiveness of the technique for domain adaptation. Here, the task involves estimating the core temperature of a Li-ion battery from electrochemical impedance spectroscopy (EIS) measurements. EIS measures the frequency-dependent impedance of a system and is correlated with the battery state, including the core temperature of the battery. Consequently, regression models trained to predict the core temperature of a battery from EIS measurements enable non-invasive battery state monitoring to ensure their safe operation.

However, training these models involves using a large amount of data collected over extended periods under various charge or discharge protocols. Labeled training data to monitor the core temperature often involves cycling batteries in a thermal chamber under thermal equilibrium conditions at various battery states and temperatures. Generating such extensive datasets for every new battery cell (e.g., with different chemistry or form factor) is impractical and time-consuming. Instead, transfer learning offers a more efficient solution: by collecting a small amount of data for a new battery (e.g., the target domain)-such as EIS measurements at a few specific temperatures- and augmenting this sparse dataset by transporting data from another battery (e.g., the source domain) that has been collected over a wider range of temperatures. This enables rapid model development with improved accuracy without exhaustive data collection.

In this experiment, seven 3Ah lithium cobalt-oxide (LCO) pouch cells were used as the source domain and three different types of cells were used as the target domain:

1) 65Ah lithium nickel manganese cobalt (NMC) oxide pouch cell,
2) 1.1 Ah lithium iron phosphate (LFP) cylindrical cell, and
3) 3.2 Ah lithium nickel cobalt aluminum (NCA) oxide cylindrical cell.

Hereafter, the four cell types are referred to by their nominal capacities - 3Ah, 65Ah, 1.1Ah, and 3.2Ah.

Each cell was placed in an individual thermal chamber, and multifrequency EIS measurements were collected at thermal equilibrium at different temperatures. Auxiliary electrical data such as current, voltage and state of charge (SoC) was also collected. For the source domain, data was collected at temperatures ranging from 10° C to 50° C in 5° C increments. Data for target domain cells was collected at {10° C, 50° C}, or {10° C, 30° C, 50° C}. For training a baseline regressor in the target-domain that uses a broader range of temperatures, additional data was collected for the same temperatures as the source.

The datasets were split into training and testing sets, with 40% of the data used for training, 20% used for validation, and the remaining 40% used for testing. The training dataset size was at most 13% of the source domain dataset size for the 65Ah cell, and at most 1% of the source domain dataset size for the 1.1Ah and 3.2Ah cells.

Given this experimental context, the following workflow was used to achieve domain adaptation using the technique. The target domain data was augmented using the source-driven smearing procedure (2). A multilayer perceptron (MLP)-based regression model was trained on the augmented target domain data to estimate the core temperature of the battery from EIS measurements. The network used three hidden layers and a hidden layer dimensionality of ten for the 65Ah cell, and two hidden layers and hidden layer dimensionality of fifteen for the 1.1Ah and 3.2Ah cells. The network was trained on the first three principal components extracted from the training data. This approach is compared below against two domain adaptation baselines. In the first baseline, the target data is augmented with the source data transformed via sliced Wasserstein optimal transport. In the second baseline, called target smearing, the target dataset is augmented with samples drawn by applying the smearing transformation to conditional mean and covariance estimates obtained by fitting a polynomial to the conditional moments of the available target data. The results are given in terms of the median absolute error in core temperature prediction on the target-domain test set. Both the source and target data can be decomposed according to (1) where $\mu_D$ and $\sigma_D$ can be approximated by simple functions of $Y_D$. Also, the random vector $Z$ is approximately disentangled from the temperature, validating the sampling assumption used by the technique.

The following tables illustrates the median absolute error in temperature estimation for the technique as compared to the several baselines.

| Target battery type | 65Ah NMC | | 1.1Ah LFP | | 3.2Ah NCA | |
|---|---|---|---|---|---|---|
| Number of training temps in $T$ | 2 | 3 | 2 | 3 | 2 | 3 |
| $[\mathbb{D}_T]/[\mathbb{D}_S]$ (%) | 8% | 13% | 0.5% | 0.9% | 0.6% | 1% |
| Trained with all temps | 0.76 | 1.12 | 2.01 | 2.13 | 2.21 | 2.08 |
| No transfer learning | 5.95 | 1.87 | 10.08 | 3.02 | 6.37 | 3.32 |
| Model fine-tuning | 5.55 | 1.24 | 7.58 | 2.44 | 9.39 | 2.53 |
| Sliced OT | 9.56 | 2.42 | 9.50 | 2.25 | 8.20 | 4.32 |
| Target Smearing | 6.29 | 0.99 | 10.26 | 2.51 | 6.79 | 2.72 |
| Source-driven Smearing | 1.07 | 1.02 | 3.32 | 2.25 | 1.90 | 2.06 |

Thus, the technique achieves performance very close to the case where the regression model was trained on the target data collected at all nine temperatures. In particular, it outperforms the baseline approaches when the target training data is collected at two temperatures and is generally better than the baselines when the target training data is collected as three temperatures. Because of the lengthy process of achieving thermal equilibrium at chamber temperature before collection can begin, these gains are of significant practical relevance.

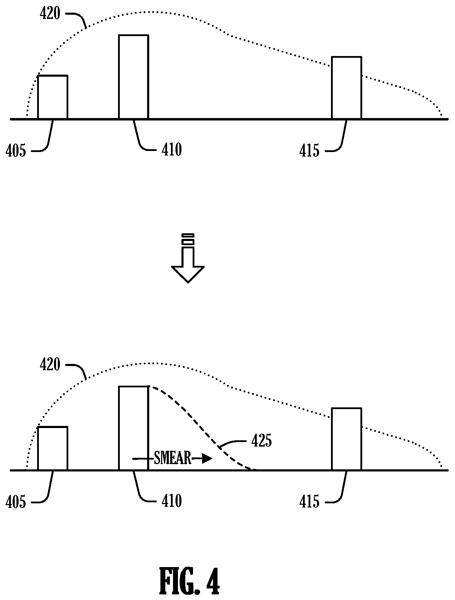

FIG. 4. illustrates an example of smearing sparse data in a data domain, according to an embodiment. An issue can arise in the transport (e.g., as illustrated in FIG. 3) where sparse data causes distortions in the transported datapoints. To address this issue, the data in the sparse domain can be smeared (e.g., synthetic data representing a gradient from the existing data points) can be used to fill out the sparse domain prior to calculating the transport. As illustrated, consider the sparse domain 420 with sparse data points, data point 405, data point 410, and data point 415. If the distance between data point 405 and 410 is expected, it is evident that there is missing data between the data point 410 and the data point 415.

This gap can be defined in different ways, including a predefined threshold.

The bottom portion of FIG. 4 illustrates application of a distribution constraint on synthetic data 425 based the data point 410 to help fill in the gap. Although not illustrated, a similar constraint on a distribution in the other direction could be anchored at the data point 415 to further help fill in the gap. This constraint can be based on a moment derived from the source domain, such as a mean or variance, that can be conditional (e.g., based on a condition of temperature, age, current, etc. in the case of a battery device). This moment can be matched to the data point 410, for example, to provide at least a portion of the constraint on the synthetic data 425.

In an example, other aspects of the constraint can include a distribution, such as Gaussian, Bernoulli, Binomial, Poisson, Exponential, Gamma, Beta, or Dirichlet distributions among others. The Gaussian distribution, also known as the normal distribution, is defined by its mean and variance and is symmetric around the mean, often used for modeling continuous data with a central tendency. When matching the moment from the source domain, the mean or variance from the source domain can be used to set the mean or variance of the Gaussian distribution when generating the synthetic data 425 in the target domain. The Bernoulli distribution models binary outcomes and is parameterized by a single probability of success. The Binomial distribution extends the Bernoulli distribution to a fixed number of independent trials with the same success probability. The Poisson distribution models count data or the number of rare events occurring within a fixed interval. The Exponential distribution models the time between independent events that occur at a constant average rate. The Gamma distribution generalizes the Exponential distribution to model waiting times for multiple events and is characterized by shape and rate parameters. The Beta distribution models random variables constrained to the interval [0, 1] and is often applied in Bayesian inference. The Dirichlet distribution generalizes the Beta distribution to multivariate settings and is used to model probability vectors over a finite number of categories.

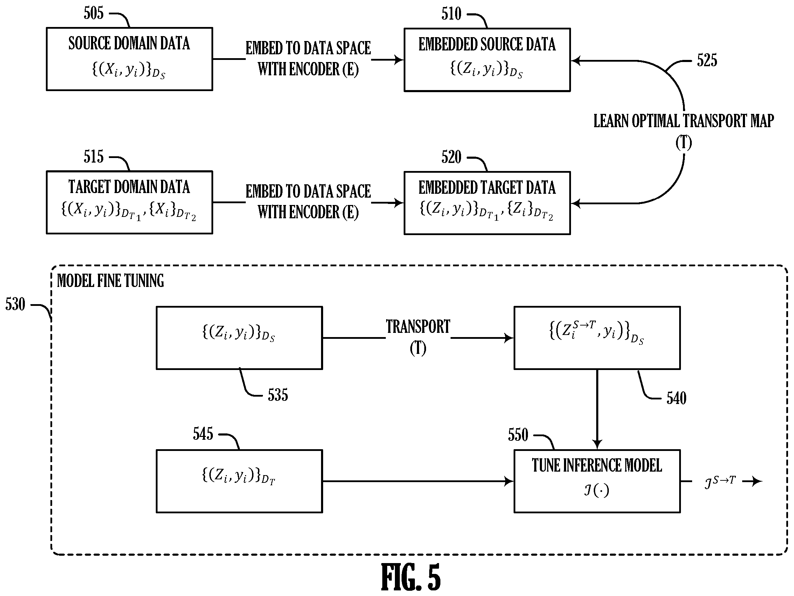

FIG. 5 illustrates an example of machine learning to generate a transport from between latent data space embedding of source domain data and latent data space embedding of target domain data, according to an embodiment. As illustrated, source domain data 505 is encoded (e.g., reduced by an encoder) to create embedded source data 510. Similarly, target domain data 515 is encoded (e.g., using the same encoder used to encode the source domain data 505) to create embedded target data. Then, an optimal transport process (e.g., such as that described above) is applied to learn a transport map 525 from the embedded target data 520 to the embedded source data 510, or vice versa. The operation on the latent data space can reduce components because, generally, the latent data space is a lower-dimensional space than the original data space (e.g., the source domain).

The directionality of the transport map 525 can be used for different purposes. For example, mapping the source domain to the target domain enables the source domain data to supplement the target domain data to train, or re-train, the ML model on the target domain. This example is illustrated in the model fine tuning 530. Here, the source domain data 535 is transported to the target domain 540 and combined with target domain data 545 to tune the inference model 550. This approach can be useful when, for example, additional target domain data is used, over time, to continue to hone the model specifically for the target domain.

Conversely, mapping the target domain to the source domain enables the ML model to operate on the transported target domain data as if it were source domain data to provide an inference. This approach can be useful when, for example, the same model will be applied (e.g., infrequently) to different target domains. In this case, it is unlikely that the additional work to fine-tune models for each domain will be worth the time or expense when the target domain data can simply be transported to the source domain to get result from the ML model. However, fine-tuning does improve the model but the extent of the training involved might be smaller, such that, for example, smaller variations to the model can be sufficient.

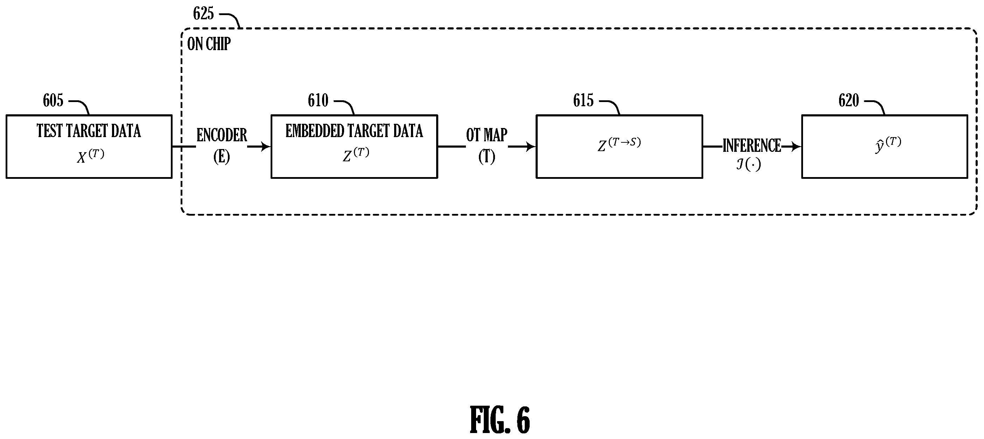

FIG. 6 illustrates an example of inference of target domain data 605 using an ML learning model trained on source domain data, according to an embodiment. The target domain data 605 (e.g., ATE test data) can be obtained (e.g., retrieved, received, delivered, etc.) by an ML pipeline (e.g., implemented in an on-chip accelerator 625). In the illustrated example, an encoder is invoked on the target domain data 605 to create embedded target data 610. The transport map (e.g., described above including the smearing of the embedded target data 610) transports the embedded target data 610 to the source domain to create an embedded representation 615 upon which the ML model can operate (e.g., accept as input) to produce a result 620. This configuration leverages on-chip models trained on the source domain to the target domain.

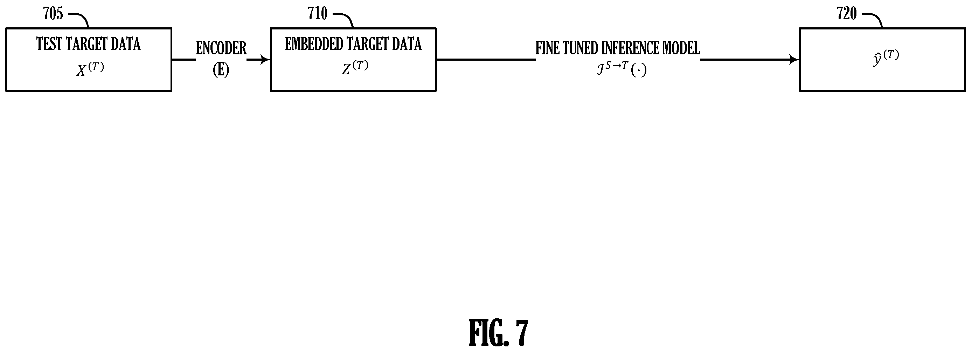

FIG. 7 illustrates an example of inference of target domain data using a machine-learning model trained on source domain data transformed to the target domain using a transport map, according to an embodiment. In this embodiment, the ML model is retrained for the target domain using data from the source domain that has been transported into the target domain. The retrained model is illustrated as $\mathcal{J}^{S \to T}$. Here, the target data can be processed by the retrained model directly. Thus, the target domain data 705 is obtained and encoded to the latent data space to create the embedded target data 710. The retrained model then operates directly on the target data embedding to produce the result 720.

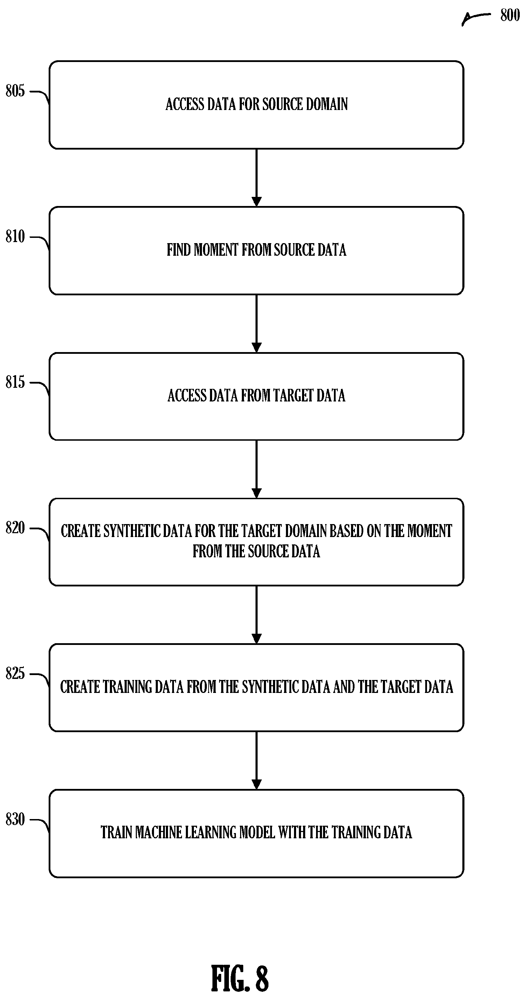

FIG. 8 illustrates a flow diagram of an example of a method 800 for transfer learning domain adaptation, according to an embodiment. The operations of the method 800 are performed by computer hardware, such as that described above or below (e.g., processing circuitry).

At operation 805, first media that includes first data in a source domain is accessed. In an example, the source domain is a first set of measurements for a first product. In an example, the first product is of a type. In an example, the type is a battery.

At operation 810, a moment is derived from the first data. In an example, the moment is a quantitative measure of a statistical distribution. In an example, the moment is a conditional. In an example, a condition of the moment is temperature, current, or age. In an example, the moment is a mean or a variance.

At operation 815, second media that includes second data in a target domain is accessed. In an example, the second data is sparse in the target domain, the second data including a gap beyond a threshold.

In an example, the target domain is a second set of measurements for a second product. In an example, the first produce and the second product are different products of the same type. In an example, where the type is a battery, the first product has a different chemistry or a different form factor than the second product. In an example, the first set of measurements and the second set of measurements include respective electrochemical impedance spectroscopy (EIS) data, voltage, current, or state-of-charge data for the first product and the second product.

At operation 820, synthetic data is created for the target domain based on the moment. In an example, where the second data includes a gap in the target domain, the synthetic data fills a portion of the gap in the target domain to create the training data. In an example, creating the synthetic data based on the moment includes smearing a portion of the second data to fill the portion of the gap constrained by the moment.

At operation 825, training data is created from the synthetic data and the second data. In an example, creating training data from the synthetic data and the second data includes combining the synthetic data and the second data to create interim data. In an example, a transform is created to map the first data to the interim data via a training process to map a data point from the source domain to a corresponding data point in the target domain. In an example, the transform is applied to the first data to provide additional synthetic data. In an example, the additional synthetic data is combined with the interim data. In an example, the transform is a type of optimal transport from the source domain to the target domain. In an example, Sliced Wasserstein Transport (SWT) is used as a loss function in the training process to obtain the optimal transport from the source domain to the target domain.

At operation 830, a machine learning model is trained using the training data. This machine learning model is trained to accept target domain data as input and produce an output. In an example, where the second product is a battery, the output from the machine learning model is a core temperature of the battery.

In an example, the first product has a different chemistry or a different form factor than the second product. In an example, the first set of measurements and the second set of measurements include respective electrochemical impedance spectroscopy (EIS) data, voltage, current, or state-of-charge data for the first product and the second product. In an example, the output from the machine learning model is a core temperature of the battery.

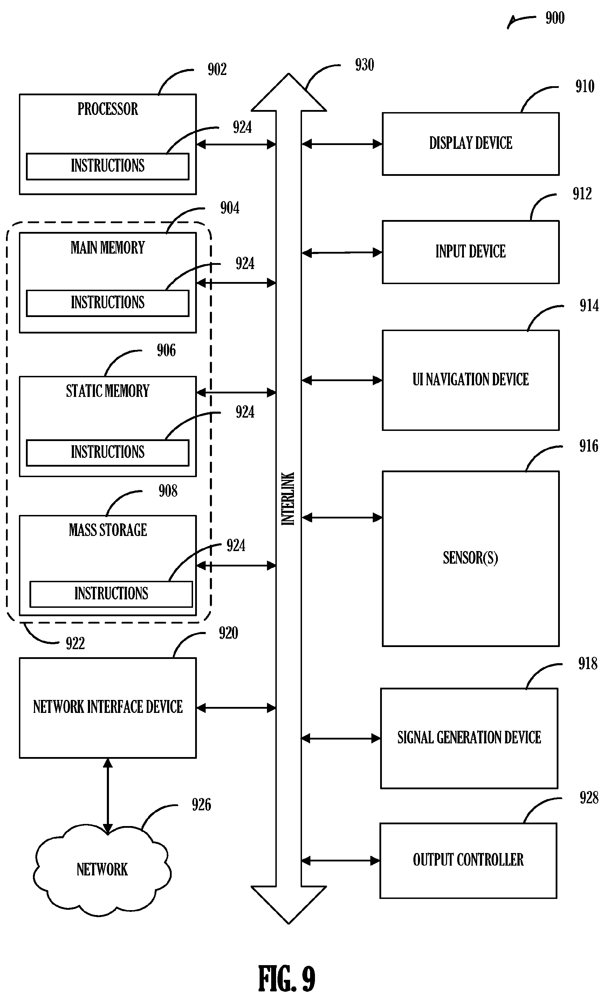

FIG. 9 illustrates a block diagram of an example machine 900 upon which any one or more of the techniques (e.g., methodologies) discussed herein may perform. Examples, as described herein, may include, or may operate by, logic or a number of components, or mechanisms in the machine 900. Circuitry (e.g., processing circuitry) is a collection of circuits implemented in tangible entities of the machine 900 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the machine 900 follow.

In alternative embodiments, the machine 900 may operate as a standalone device or may be connected (e.g., networked) to other machines. In a networked deployment, the machine 900 may operate in the capacity of a server machine, a client machine, or both in server-client network environments. In an example, the machine 900 may act as a peer machine in peer-to-peer (P2P) (or other distributed) network environment. The machine 900 may be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

The machine (e.g., computer system) 900 may include a hardware processor 902 (e.g., a central processing unit (CPU), a graphics processing unit (GPU), a hardware processor core, or any combination thereof), a main memory 904, a static memory (e.g., memory or storage for firmware, microcode, a basic-input-output (BIOS), unified extensible firmware interface (UEFI), etc.) 906, and mass storage 908 (e.g., hard drives, tape drives, flash storage, or other block devices) some or all of which may communicate with each other via an interlink (e.g., bus) 930. The machine 900 may further include a display unit 910, an alphanumeric input device 912 (e.g., a keyboard), and a user interface (UI) navigation device 914 (e.g., a mouse). In an example, the display unit 910, input device 912 and UI navigation device 914 may be a touch screen display. The machine 900 may additionally include a storage device (e.g., drive unit) 908, a signal generation device 918 (e.g., a speaker), a network interface device 920, and one or more sensors 916, such as a global positioning system (GPS) sensor, compass, accelerometer, or other sensor. The machine 900 may include an output controller 928, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

Registers of the processor 902, the main memory 904, the static memory 906, or the mass storage 908 may be, or include, a machine readable medium 922 on which is stored one or more sets of data structures or instructions 924 (e.g., software) embodying or utilized by any one or more of the techniques or functions described herein. The instructions 924 may also reside, completely or at least partially, within any of registers of the processor 902, the main memory 904, the static memory 906, or the mass storage 908 during execution thereof by the machine 900. In an example, one or any combination of the hardware processor 902, the main memory 904, the static memory 906, or the mass storage 908 may constitute the machine readable media 922. While the machine readable medium 922 is illustrated as a single medium, the term "machine readable medium" may include a single medium or multiple media (e.g., a centralized or distributed database, and/or associated caches and servers) configured to store the one or more instructions 924.

The term "machine readable medium" may include any medium that is capable of storing, encoding, or carrying instructions for execution by the machine 900 and that cause the machine 900 to perform any one or more of the techniques of the present disclosure, or that is capable of storing, encoding or carrying data structures used by or associated with such instructions. Nonlimiting machine readable medium examples may include solid-state memories, optical media, magnetic media, and signals (e.g., radio frequency signals, other photon based signals, sound signals, etc.). In an example, a non-transitory machine readable medium comprises a machine readable medium with a plurality of particles having invariant (e.g., rest) mass, and thus are compositions of matter. Accordingly, non-transitory machine-readable media are machine readable media that do not include transitory propagating signals. Specific examples of non-transitory machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magnetooptical disks; and CD-ROM and DVD-ROM disks.

In an example, information stored or otherwise provided on the machine readable medium 922 may be representative of the instructions 924, such as instructions 924 themselves or a format from which the instructions 924 may be derived. This format from which the instructions 924 may be derived may include source code, encoded instructions (e.g., in compressed or encrypted form), packaged instructions (e.g., split into multiple packages), or the like. The information representative of the instructions 924 in the machine readable medium 922 may be processed by processing circuitry into the instructions to implement any of the operations discussed herein. For example, deriving the instructions 924 from the information (e.g., processing by the processing circuitry) may include: compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions 924.

In an example, the derivation of the instructions 924 may include assembly, compilation, or interpretation of the information (e.g., by the processing circuitry) to create the instructions 924 from some intermediate or preprocessed format provided by the machine readable medium 922. The information, when provided in multiple parts, may be combined, unpacked, and modified to create the instructions 924. For example, the information may be in multiple compressed source code packages (or object code, or binary executable code, etc.) on one or several remote servers. The source code packages may be encrypted when in transit over a network and decrypted, uncompressed, assembled (e.g., linked) if necessary, and compiled or interpreted (e.g., into a library, stand-alone executable etc.) at a local machine, and executed by the local machine.

The instructions 924 may be further transmitted or received over a communications network 926 using a transmission medium via the network interface device 920 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), LoRa/LoRaWAN, or satellite communication networks, mobile telephone networks (e.g., cellular networks such as those complying with 3G, 4G LTE/LTE-A, or 5G standards), Plain Old Telephone (POTS) networks, and wireless data networks (e.g., Institute of Electrical and Electronics Engineers (IEEE) 802.11 family of standards known as Wi-Fi®, IEEE 802.15.4 family of standards, peer-to-peer (P2P) networks, among others. In an example, the network interface device 920 may include one or more physical jacks (e.g., Ethernet, coaxial, or phone jacks) or one or more antennas to connect to the communications network 926. In an example, the network interface device 920 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 900, and includes digital or analog communications signals or other intangible medium to facilitate communication of such software. A transmission medium is a machine readable medium.

Additional Notes & Examples

Example 1 is a device for transfer learning domain adaptation, the device comprising: an interface configured to: access first media that includes first data in a source domain; and access second media that include second data in a target domain; a memory including instructions; and processing circuitry that, when in operation, is configured by the instructions to: access, via the interface, the first data from the first media; derive a moment from the first data, the moment being a quantitative measure of a statistical distribution; access, via the interface, the second data from the second media; create synthetic data for the target domain based on the moment; create training data from the synthetic data and the second data; and train a machine learning model using the training data, the machine learning model trained to accept target domain data as input and produce an output.

In Example 2, the subject matter of Example 1, wherein the second data is sparse in the target domain, the second data including a gap beyond a threshold.

In Example 3, the subject matter of Example 2, wherein the synthetic data fills a portion of the gap in the target domain to create the training data.

In Example 4, the subject matter of Example 3, wherein, to create the synthetic data based on the moment, the processing circuitry is configured to smear a portion of the second data to fill the portion of the gap constrained by the moment.

In Example 5, the subject matter of any of Examples 1-4, wherein the moment is conditional.

In Example 6, the subject matter of Example 5, wherein a condition of the moment is temperature, current, or age.

In Example 7, the subject matter of any of Examples 1-6, wherein the moment is a mean or a variance.

In Example 8, the subject matter of any of Examples 1-7, wherein, to create the training data from the synthetic data and the second data, the processing circuitry is configured to: combine the synthetic data and the second data to create interim data; create a transform to map the first data to the interim data via a training process to map a data point from the source domain to a corresponding data point in the target domain; apply the transform to the first data to provide additional synthetic data; and combine the additional synthetic data with the interim data.

In Example 9, the subject matter of Example 8, wherein the transform is a type of optimal transport from the source domain to the target domain.

In Example 10, the subject matter of Example 9, wherein Sliced Wasserstein Transport (SWT) is used as a loss function in the training process to obtain the optimal transport from the source domain to the target domain.

In Example 11, the subject matter of any of Examples 1-10, wherein the source domain is a first set of measurements for a first product and the target domain is a second set of measurements for a second product.

In Example 12, the subject matter of Example 11, wherein the first product and the second product are different products of a same type.

In Example 13, the subject matter of Example 12, wherein the same type is a battery, and wherein the first product has a different chemistry or a different form factor than the second product.

In Example 14, the subject matter of Example 13, wherein the first set of measurements and the second set of measurements include respective electrochemical impedance spectroscopy (EIS) data, voltage, current, or state-of-charge data for the first product and the second product.

In Example 15, the subject matter of Example 14, wherein the output from the machine learning model is a core temperature of the battery.

Example 16 is a method for transfer learning domain adaptation, the method comprising: accessing first media that includes first data in a source domain; deriving a moment from the first data, the moment being a quantitative measure of a statistical distribution; accessing second media that includes second data in a target domain; creating synthetic data for the target domain based on the moment; creating training data from the synthetic data and the second data; and training a machine learning model using the training data, the machine learning model trained to accept target domain data as input and produce an output.

In Example 17, the subject matter of Example 16, wherein the second data is sparse in the target domain, the second data including a gap beyond a threshold.

In Example 18, the subject matter of Example 17, wherein the synthetic data fills a portion of the gap in the target domain to create the training data.

In Example 19, the subject matter of Example 18, wherein creating the synthetic data based on the moment includes smearing a portion of the second data to fill the portion of the gap constrained by the moment.

In Example 20, the subject matter of any of Examples 16-19, wherein the moment is conditional.

In Example 21, the subject matter of Example 20, wherein a condition of the moment is temperature, current, or age.

In Example 22, the subject matter of any of Examples 16-21, wherein the moment is a mean or a variance.

In Example 23, the subject matter of any of Examples 16-22, wherein creating the training data from the synthetic data and the second data includes: combining the synthetic data and the second data to create interim data; creating a transform to map the first data to the interim data via a training process to map a data point from the source domain to a corresponding data point in the target domain; applying the transform to the first data to provide additional synthetic data; and combining the additional synthetic data with the interim data.

In Example 24, the subject matter of Example 23, wherein the transform is a type of optimal transport from the source domain to the target domain.

In Example 25, the subject matter of Example 24, wherein Sliced Wasserstein Transport (SWT) is used as a loss function in the training process to obtain the optimal transport from the source domain to the target domain.

In Example 26, the subject matter of any of Examples 16-25, wherein the source domain is a first set of measurements for a first product and the target domain is a second set of measurements for a second product.

In Example 27, the subject matter of Example 26, wherein the first product and the second product are different products of a same type.

In Example 28, the subject matter of Example 27, wherein the same type is a battery, and wherein the first product has a different chemistry or a different form factor than the second product.

In Example 29, the subject matter of Example 28, wherein the first set of measurements and the second set of measurements include respective electrochemical impedance spectroscopy (EIS) data, voltage, current, or state-of-charge data for the first product and the second product.

In Example 30, the subject matter of Example 29, wherein the output from the machine learning model is a core temperature of the battery.

Example 31 is a machine readable medium including instructions for transfer learning domain adaptation, the instruction, when executed by processing circuitry, cause the processing circuitry to perform operations comprising: accessing first media that includes first data in a source domain; deriving a moment from the first data, the moment being a quantitative measure of a statistical distribution; accessing second media that includes second data in a target domain; creating synthetic data for the target domain based on the moment; creating training data from the synthetic data and the second data; and training a machine learning model using the training data, the machine learning model trained to accept target domain data as input and produce an output.

In Example 32, the subject matter of Example 31, wherein the second data is sparse in the target domain, the second data including a gap beyond a threshold.

In Example 33, the subject matter of Example 32, wherein the synthetic data fills a portion of the gap in the target domain to create the training data.

In Example 34, the subject matter of Example 33, wherein creating the synthetic data based on the moment includes smearing a portion of the second data to fill the portion of the gap constrained by the moment.

In Example 35, the subject matter of any of Examples 31-34, wherein the moment is conditional.

In Example 36, the subject matter of Example 35, wherein a condition of the moment is temperature, current, or age.

In Example 37, the subject matter of any of Examples 31-36, wherein the moment is a mean or a variance.

In Example 38, the subject matter of any of Examples 31-37, wherein creating the training data from the synthetic data and the second data includes: combining the synthetic data and the second data to create interim data; creating a transform to map the first data to the interim data via a training process to map a data point from the source domain to a corresponding data point in the target domain; applying the transform to the first data to provide additional synthetic data; and combining the additional synthetic data with the interim data.

In Example 39, the subject matter of Example 38, wherein the transform is a type of optimal transport from the source domain to the target domain.

In Example 40, the subject matter of Example 39, wherein Sliced Wasserstein Transport (SWT) is used as a loss function in the training process to obtain the optimal transport from the source domain to the target domain.

In Example 41, the subject matter of any of Examples 31-40, wherein the source domain is a first set of measurements for a first product and the target domain is a second set of measurements for a second product.

In Example 42, the subject matter of Example 41, wherein the first product and the second product are different products of a same type.

In Example 43, the subject matter of Example 42, wherein the same type is a battery, and wherein the first product has a different chemistry or a different form factor than the second product.

In Example 44, the subject matter of Example 43, wherein the first set of measurements and the second set of measurements include respective electrochemical impedance spectroscopy (EIS) data, voltage, current, or state-of-charge data for the first product and the second product.

In Example 45, the subject matter of Example 44, wherein the output from the machine learning model is a core temperature of the battery.

Example 46 is a system for transfer learning domain adaptation, the system comprising: means for accessing first media that includes first data in a source domain; means for deriving a moment from the first data, the moment being a quantitative measure of a statistical distribution; means for accessing second media that includes second data in a target domain; means for creating synthetic data for the target domain based on the moment; means for creating training data from the synthetic data and the second data; and means for training a machine learning model using the training data, the machine learning model trained to accept target domain data as input and produce an output.

In Example 47, the subject matter of Example 46, wherein the second data is sparse in the target domain, the second data including a gap beyond a threshold.

In Example 48, the subject matter of Example 47, wherein the synthetic data fills a portion of the gap in the target domain to create the training data.

In Example 49, the subject matter of Example 48, wherein the means for creating the synthetic data based on the moment include means for smearing a portion of the second data to fill the portion of the gap constrained by the moment.

In Example 50, the subject matter of any of Examples 46-49, wherein the moment is conditional.

In Example 51, the subject matter of Example 50, wherein a condition of the moment is temperature, current, or age.

In Example 52, the subject matter of any of Examples 46-51, wherein the moment is a mean or a variance.

In Example 53, the subject matter of any of Examples 46-52, wherein the means for creating the training data from the synthetic data and the second data include: means for combining the synthetic data and the second data to create interim data; means for creating a transform to map the first data to the interim data via a training process to map a data point from the source domain to a corresponding data point in the target domain; means for applying the transform to the first data to provide additional synthetic data; and means for combining the additional synthetic data with the interim data.

In Example 54, the subject matter of Example 53, wherein the transform is a type of optimal transport from the source domain to the target domain.

In Example 55, the subject matter of Example 54, wherein Sliced Wasserstein Transport (SWT) is used as a loss function in the training process to obtain the optimal transport from the source domain to the target domain.

In Example 56, the subject matter of any of Examples 46-55, wherein the source domain is a first set of measurements for a first product and the target domain is a second set of measurements for a second product.

In Example 57, the subject matter of Example 56, wherein the first product and the second product are different products of a same type.

In Example 58, the subject matter of Example 57, wherein the same type is a battery, and wherein the first product has a different chemistry or a different form factor than the second product.

In Example 59, the subject matter of Example 58, wherein the first set of measurements and the second set of measurements include respective electrochemical impedance spectroscopy (EIS) data, voltage, current, or state-of-charge data for the first product and the second product.

In Example 60, the subject matter of Example 59, wherein the output from the machine learning model is a core temperature of the battery.

Example 61 is at least one machine-readable medium including instructions that, when executed by processing circuitry, cause the processing circuitry to perform operations to implement of any of Examples 1-60.

Example 62 is an apparatus comprising means to implement of any of Examples 1-60.

Example 63 is a system to implement of any of Examples 1-60.

Example 64 is a method to implement of any of Examples 1-60.

The above detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment. The scope of the embodiments should be determined with reference to the appended claims, along with the full scope of equivalents to which such claims are entitled.

## Claims

1. A device for transfer learning domain adaptation, the device comprising:

   an interface configured to:

   access first media that includes first data in a source domain; and
   access second media that include second data in a target domain;

   a memory including instructions; and
   processing circuitry that, when in operation, is configured by the instructions to:

   access, via the interface, the first data from the first media;
   derive a moment from the first data, the moment being a quantitative measure of a statistical distribution;
   access, via the interface, the second data from the second media;
   create synthetic data for the target domain based on the moment;
   create training data from the synthetic data and the second data; and
   train a machine learning model using the training data, the machine learning model trained to accept target domain data as input and produce an output.

2. The device of claim 1, wherein the second data is sparse in the target domain, the second data including a gap beyond a threshold.

3. The device of claim 2, wherein the synthetic data fills a portion of the gap in the target domain to create the training data.

4. The device of claim 3, wherein, to create the synthetic data based on the moment, the processing circuitry is configured to smear a portion of the second data to fill the portion of the gap constrained by the moment.

5. The device of any of claims 1 to 4, wherein, to create the training data from the synthetic data and the second data, the processing circuitry is configured to:

   combine the synthetic data and the second data to create interim data;

create a transform to map the first data to the interim data via a training process to map a data point from the source domain to a corresponding data point in the target domain;
apply the transform to the first data to provide additional synthetic data; and
combine the additional synthetic data with the interim data.

6. A non-transitory machine readable medium including instructions for transfer learning domain adaptation, the instructions, when executed by processing circuitry, cause the processing circuitry to perform operations comprising:

accessing first media that includes first data in a source domain;
deriving a moment from the first data, the moment being a quantitative measure of a statistical distribution;
accessing second media that includes second data in a target domain;
creating synthetic data for the target domain based on the moment;
creating training data from the synthetic data and the second data; and
training a machine learning model using the training data, the machine learning model trained to accept target domain data as input and produce an output.

7. The machine readable medium of claim 6, wherein the second data is sparse in the target domain, the second data including a gap beyond a threshold.

8. The machine readable medium of claim 7, wherein the synthetic data fills a portion of the gap in the target domain to create the training data.

9. The machine readable medium of claim 8, wherein creating the synthetic data based on the moment includes smearing a portion of the second data to fill the portion of the gap constrained by the moment.

10. The machine readable medium of any of claims 6 to 9, or the device of any of claims 1 to 5, wherein the moment is conditional.

11. The machine readable medium of any of claims 6 to 10, wherein creating the training data from the synthetic data and the second data includes:

combining the synthetic data and the second data to create interim data;
creating a transform to map the first data to the interim data via a training process to map a data point from the source domain to a corresponding data point in the target domain;
applying the transform to the first data to provide additional synthetic data; and
combining the additional synthetic data with the interim data.

12. The machine readable medium of claim 11, or the device of claim 5, wherein the transform is a type of optimal transport from the source domain to the target domain.

13. The machine readable medium of any of claims 6 to 12, or the device of any of claims 1 to 5, 10, or 12, wherein the source domain is a first set of measurements for a first product and the target domain is a second set of measurements for a second product.

14. The machine readable medium or device of claim 13, wherein the first product and the second product are different products of a same type.

15. The machine readable medium or device of claim 14, wherein the same type is a battery, and wherein the first product has a different chemistry or a different form factor than the second product.

**FIG. 1**

**FIG. 2**

FIG. 3

**FIG. 4**

EP 4 708 158 A1

**505** SOURCE DOMAIN DATA $\{(X_i, y_i)\}_{D_S}$ →EMBED TO DATA SPACE WITH ENCODER (E)→ **510** EMBEDDED SOURCE DATA $\{(Z_i, y_i)\}_{D_S}$

**525** LEARN OPTIMAL TRANSPORT MAP (T)

**515** TARGET DOMAIN DATA $\{(X_i, y_i)\}_{D_{T_1}}, \{X_i\}_{D_{T_2}}$ →EMBED TO DATA SPACE WITH ENCODER (E)→ **520** EMBEDDED TARGET DATA $\{(Z_i, y_i)\}_{D_{T_1}}, \{Z_i\}_{D_{T_2}}$

**530** MODEL FINE TUNING

**535** $\{(Z_i, y_i)\}_{D_S}$ →TRANSPORT (T)→ **540** $\{(Z_i^{S \to T}, y_i)\}_{D_S}$

**545** $\{(Z_i, y_i)\}_{D_T}$ → **550** TUNE INFERENCE MODEL $\mathcal{J}(\cdot)$ → $\mathcal{J}^{S \to T}$ →

**FIG. 5**

625 — ON CHIP

605 — TEST TARGET DATA $X^{(T)}$ → ENCODER (E) → 610 — EMBEDDED TARGET DATA $Z^{(T)}$ → OT MAP (T) → 615 — $Z^{(T \to S)}$ → INFERENCE $\mathcal{I}(\cdot)$ → 620 — $\hat{y}^{(T)}$

FIG. 6

EP 4 708 158 A1

| 705 ⌐ | | 710 ⌐ | | | 720 ⌐ |
|---|---|---|---|---|---|
| TEST TARGET DATA $X^{(T)}$ | ENCODER (E) → | EMBEDDED TARGET DATA $Z^{(T)}$ | FINE TUNED INFERENCE MODEL $\mathcal{J}^{S \to T}(\cdot)$ → | | $\hat{y}^{(T)}$ |

**FIG. 7**

800

805 — ACCESS DATA FOR SOURCE DOMAIN

810 — FIND MOMENT FROM SOURCE DATA

815 — ACCESS DATA FROM TARGET DATA

820 — CREATE SYNTHETIC DATA FOR THE TARGET DOMAIN BASED ON THE MOMENT FROM THE SOURCE DATA

825 — CREATE TRAINING DATA FROM THE SYNTHETIC DATA AND THE TARGET DATA

830 — TRAIN MACHINE LEARNING MODEL WITH THE TRAINING DATA

FIG. 8

900

PROCESSOR — 902

INSTRUCTIONS — 924

MAIN MEMORY — 904

INSTRUCTIONS — 924

STATIC MEMORY — 906

INSTRUCTIONS — 924

MASS STORAGE — 908

INSTRUCTIONS — 924

922

NETWORK INTERFACE DEVICE — 920

NETWORK — 926

INTERLINK — 930

DISPLAY DEVICE — 910

INPUT DEVICE — 912

UI NAVIGATION DEVICE — 914

SENSOR(S) — 916

SIGNAL GENERATION DEVICE — 918

OUTPUT CONTROLLER — 928

FIG. 9

European Patent Office
Europäisches Patentamt
European Patent Office
Office européen des brevets

# EUROPEAN SEARCH REPORT

Application Number

EP 25 20 0048

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG FUJIN ET AL: "A transferable lithium-ion battery remaining useful life prediction method from cycle-consistency of degradation trend", JOURNAL OF POWER SOURCES, ELSEVIER, AMSTERDAM, NL, vol. 521, 8 January 2022 (2022-01-08), XP086937287, ISSN: 0378-7753, DOI: 10.1016/J.JPOWSOUR.2022.230975 [retrieved on 2022-01-08] * page 6, paragraph 3.1 * * page 4, paragraph 2.3 - page 5 * * page 12, paragraph 4 * * page 11; figure 7 * | 1-15 | INV. G06N20/00 G01R31/36 |
| A | QIU X ET AL: "A conditional generative adversarial network-based synthetic data augmentation technique for battery state-of-charge estimation", APPLIED SOFT COMPUTING 20230701 ELSEVIER LTD GBR, vol. 142, 1 July 2023 (2023-07-01), XP002821461, DOI: 10.1016/J.ASOC.2023.110281 * abstract * | 1-15 | |
| T | KELKAR VARUN ET AL: "Regularized Domain Adaptation for Estimation Tasks in Partially Observed Target Domains", ICASSP 2025, 2025 IEEE INTERNATIONAL CONFERENCE ON ACOUSTICS, SPEECH AND SIGNAL PROCESSING (ICASSP), 6 April 2025 (2025-04-06), pages 1-5, XP093291387, DOI: 10.1109/ICASSP49660.2025.10889315 ISBN: 979-8-3503-6874-1 * abstract * | | TECHNICAL FIELDS SEARCHED (IPC) G06N G01R |

The present search report has been drawn up for all claims

| Place of search | Date of completion of the search | Examiner |
|---|---|---|
| The Hague | 21 November 2025 | De Meyer, Arnaud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63690856